# EUROPEAN PATENT APPLICATION

(11) **EP 3 790 049 A1**
(43) Date of publication of application: **10.03.2021**
(21) Application number: 19465554.4
(22) Date of filing: 05.09.2019
(51) Int. Cl.: H01L 25/075, H01L 33/44, H01L 33/50

(54) **A PIXEL MODULE, A LIGHT EMITTING DEVICE AND A METHOD FOR PRODUCING A PIXEL MODULE**

(71) Applicant: Continental Automotive GmbH, 30165 Hannover (DE)
(72) Inventor: Pasca, Andrei, 300441 Timisoara (RO)
(74) Representative: Continental Corporation

(57) **Abstract**

The invention relates to a pixel module (1,1a,..1d) comprising of at least a plurality of sub-pixels, the pixel module (1,1a,...,1d) comprising:
a substrate (2) for semiconductor light sources,
a plurality of semiconductor light sources that are mounted directly or indirectly on the top of the substrate, the semiconductor light sources emit a first radiation of almost monochromatic light,
a colour layer (4) arranged in the beam path of the first radiation,
the colour layer (4) having openings (5) corresponding to the resulting sub-pixels (6,7,8), wherein at least some of the openings (5) are filled with a converting material, which converts for each filled opening (5) the first radiation, into at least one desired second radiation, wherein the first radiation is of a high energy first frequency when in operation and each second radiation is of a lower energy frequency when in operation.

Further the invention relates to a light emitting device comprising an array of pixel modules and to a method for producing a pixel module.

## Description

The invention relates to a pixel module for a display, the pixel module comprising several sub-pixels, preferably MicroLEDs sub-pixels. Further the invention relates to a light emitting device comprising an array of pixel modules and to a method for producing a pixel module.

Considering a common sized display, for example a full high definition display having a resolution of 1920 pixels by 1080 pixels, each consisting of at least three separate colour subpixels. There will be in excess of 6 million individual in-organic LEDs that must be picked and placed on the display substrate.

This places an important time constraint on the production of large colour MicroLED displays and much focus is directed on means to reliably place the individual subcomponents on the substrate. Here, the direct problem associated with the time constraint is the resulting system cost as longer processing times for a single part are limiting the production line's throughput and hence, make the system suitable only for select applications.

By producing of thinner and smaller devices, it becomes more and more difficult to integrate a system that has rather large dimensions on all three physical axes.

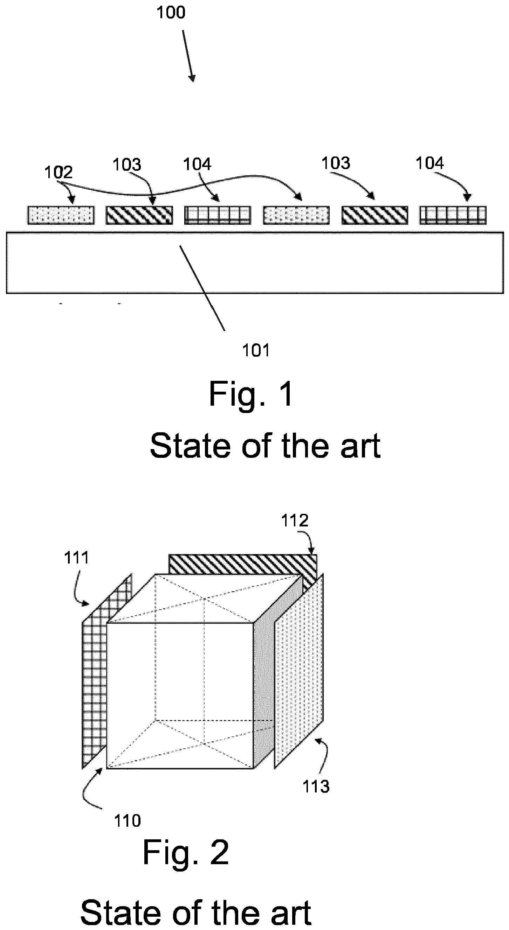

Unlike Organic Light Emitting Diodes (OLEDs) which may be produced directly tuned for different parts of the spectrum on the same substrate by, for example, a printing process, inorganic LEDs require different, incompatible, substrates in order to produce different colours. These are for instance gallium arsenide (GaAs) for the red part of the spectrum and indium gallium nitride (InGaN) for the blue part of the spectrum. Because of this, in order to produce a colour display using micro LEDs the industry provides basically two major approaches: the pixel module 100 and the optical module 110 (FIG 1, FIG 2) according to the state of the art.

FIG 1 shows a first embodiment of a pixel module 100 according to the state of the art.

The pixel module 100 according to the state of the art for a MicorLED display consists of arrays of micrometer size inorganic Light Emitting Diodes (LEDs) 102,103, 104 arranged on a substrate 101. In addition to the physical support of the array, the substrate 101 is used also to provide the driving signals to the individual LEDs 102,103,104 from the array. In order to produce different colours on a display, the industry standard is to use a mix of at least three primary different colours, red, green and blue, produces by a green LED 104, a red LED 103 and a blue LED 102. For self-emissive displays, the colours are created by the light emitting elements themselves, each pixel consisting of a set of specifically tuned sub-elements that emit light usually in the red, green and blue parts of the visible spectrum.

By the first pixel module 100 each individual micro LEDs 102, 102, 103 is transferred mechanically on the display's substrate 101. The first pixel module 100 is using differently coloured LEDs 102,103, 104 to create the required coloured sub-pixels.

FIG 2 shows a second embodiment of a pixel module 110 according to the state of the art.

The pixel module 110 according to the state of the art consists in creating several separate monochromatic displays, i.e. one red display 111, one green display 112 and one blue display 113 and optically combine the outputs of the displays, for instance by using dichroic prisms, to produce a single colour image. The LEDs are transferred in bulk, on the monochromatic display's substrate. This technique eliminates the arranging of millions of individually components but, given the required optical system for image combination, is practically suited only for imaging systems having small physical sizes.

It is an object of the present invention to provide a pixel module, which can be used for easy production of a large display.

It is further an object of the present invention to provide a light emitting device with such a pixel module.

It is further an object of the present invention to provide a method for producing a pixel module.

These objects are achieved by a pixel module with the features of claim 1, by a light emitting device with the features of claim 15 and by a method for producing a pixel module with the features of claim 16 and a pixel module which is produced according to the method.

The dependent claims list further advantageous measures which can be combined with one another, as desired, in order to achieve further advantages.

The object is achieved by a pixel module comprising of at least a plurality of sub-pixels, the pixel module comprising:
a substrate for semiconductor light sources,
a plurality of semiconductor light sources that are mounted directly or indirectly on the top of the substrate, the semiconductor light sources emit a first radiation of almost monochromatic light,
a colour layer arranged in the beam path of the first radiation,
the colour layer having openings corresponding to the resulting sub-pixels, where-in at least some of the openings are filled with a converting material, which converts for each filled opening the first radiation, into at least one desired second radiation,
wherein the first radiation is of a high energy first frequency when in operation and each second radiation is of a lower energy frequency when in operation.

Preferably the converting material using differently tuned fluorescent materials or quantum dots.

Preferably the semiconductor light sources are LEDs.

The invention has recognized the possibility to downconvert high energy light for example blue - violet or ultraviolet into lower energy light for example red - green - yellow. This can be done by using differently tuned fluorescent materials or quantum dots.

The inventive pixel module comprises therefore high energy monochromatic LEDs (semiconductor light sources) to which a colour layer is bonded atop the light emissive side. The colour layer consists of openings corresponding to the resulting sub-pixels filled with a light converting material, that is capable of converting the high energy light, like violet light to red, green and blue light, and blue light to green and red light. The openings in the colour layer correspond not necessarily in a one to one fashion to the semiconductor light sources arranged on the substrate. For instance, an opening may cover an array of 2x2 or 3x3 semiconductor light sources without being limited to these strict values. This allows an easier alignment between the semiconductor light sources and the colour layer.

The inventive pixel module improves the manufacturing costs of, for example a colour MicroLED displays, by drastically reducing the production time of large display sizes.

For instance, starting from an array of blue semiconductor light sources like LEDs produced on a single wafer substrate it is possible to transfer them in bulk on the top of the substrate in a very short amount of time, then transferring them into the desired coloured sub-pixels.

By starting from semiconductor light sources with monochromatic light and adding properly tuned light converting material to the sub-pixels of the semiconductor light sources, whereby the sub-pixels are arranged in a colour sub-pixel pattern, suitable for a colour display, it is possible to produce large sized full colour MicroLED displays in a very short time.
Although the disclosure highlights only the typical case of red-green-blue type colour pixel module, the invention can be applied to any other choice of primary colours, like red-green-yellow-blue (RGYB) or red-green-blue-white (RGBW) or red-green-cyan-blue (RGCB) just to name a few of the possible colour combinations. Moreover, the same technique may be applied to produce specially purposed displays like grayscale displays, infrared or any other type obtainable starting from higher energy light monochromatic LEDs coupled with a colour layer. For in-stance, the starting semiconductor light sources may be of a green type display coupled with a colour layer filled with converting material in the openings that creates a red sub-pixel.

In a preferred embodiment the converting material for each sub-pixel is configured to downconvert the first radiation with a first frequency to a desired second radiation with a second frequency, which is to be emitted by the sub-pixel.

In another preferred embodiment the semiconductor light sources emit a first blue high energy radiation, for example with a frequency of about 610-670 THz (Terahertz). In another preferred embodiment the converting material is configured such that at least one sub-pixel emits red radiation preferably with a frequency of about 430-480 THz and at least one sub-pixel emits green radiation preferably with a frequency of about 540-610 THz.

In a preferred embodiment the semiconductor light sources emit a first violet or ultraviolet high-energy radiation preferably with a frequency of about 670-750 THz THz (Terahertz)).

In another preferred embodiment the converting material is configured such that at least one sub-pixel emits a red radiation preferably with a frequency of about 430-480 THz and at least one sub-pixel emits a green radiation preferably with a frequency of about 540-610 THz and at least one sub-pixel emits a blue radiation preferably with a frequency of about 610-670 THz.

In another preferred embodiment the first radiation is of a high energy first frequency when in operation and each second radiation is of second, lower energy frequency when in operation and wherein a colour cut filter is arranged on the top of the colour layer to cover at least the openings having converting material. In another preferred embodiment the colour cut filter is configured for blocking the first radiation of a high energy first frequency.

That's the case if the converting efficiency of the light converting material is not close to 100%. Then a non-negligible fraction of the initial light of the LEDs may be able to escape the sub-pixels together with the desired, properly colour -shifted light, degrading the desired colour of the sub-pixels. For example, assuming a red sub-pixel generated starting from a blue radiation of the LEDs. If a fraction of the initial blue light is allowed to exit this sub-pixel, the primary red colour will shift slightly towards a magenta colour. Using the colour cut filter, the stray initial light may be efficiently eliminated, leaving just the desired colour radiation. In this case, the colour cut filter may have the same spectral characteristic for all openings with converting material, as it needs to absorb only the initial incident high energy light of the LEDs.

In another preferred embodiment the first radiation is of a high energy first frequency when in operation and each second radiation is of a second, lower energy frequency when in operation, and wherein the second radiation with the second frequency does not correspond to the resulting radiation of the sub-pixels and wherein an optical filter is arranged on the top of the colour layer to cover at least the openings with converting material.

In a preferred embodiment the optical filter is configured to allow the radiation which corresponds to the resulting desired radiation of the sub-pixels to pass.

In another preferred embodiment the converting material comprises of YAG (Yttrium Aluminium Garnet).

Preferably the converting material used for the colour converting process has a broader spectral characteristic than needed for the proper colour rendering - for instance, starting from blue monochromatic LEDs, the colour layer may have the openings for the red and green sub-pixels filled with the same phosphor substance, for instance a YAG (Yttrium Aluminium Garnet) type substance, that converts the incoming blue light to a broader spectrum yellow light. In this case, the optical filter should have the spectral characteristics aligned with the corresponding sub-pixel colour - i.e. should pass the red part of the spectrum for the red sub-pixel and the green part of the spectrum for the green part of the spectrum for the green sub-pixel.

Preferably the converting material is identical for all openings. In this case, the YAG converting material must be calibrated in such a way as to allow a significant part of the, for example, starting incoming blue light, to pass through it without being affected by the donwconverting process. The final colour sub-pixels are created by having a properly tuned red, green and blue optical filter. Although the addition of the YAG converting material over the blue sub-pixel decreases the overall efficiency of the pixel module as part of blue light needed for the blue sub-pixel is lost in the downconverting process, one advantage is the simpler implementation of the uniform donwconverting material, as the same material is covering all the subpixels. This requires just a single process pass for the deposition of the color layer and then the usage of a standard colour cut filter layer. A second advantage is the same or very similar light spread functions for all sub-pixels, because of the same converting material and therefore a simple equalization scheme for the light outputs of the independent sub-pixels. Since the green and red colour sub-pixels are obtained from the original blue incoming light, their final brightness will be lower than that of the original blue.

In a preferred embodiment the semiconductor light sources are a micro LEDs.

Furthermore, the object is achieved by a light emitting device comprising an array of pixel modules according to any of the preceding claims.

Furthermore, the object is achieved by a method for producing a pixel module, comprising the steps of:
- providing a substrate,
- mounting of a plurality of semiconductor light sources on the substrate, the semiconductor light sources emit first radiation of almost monochromatic light,
- printing converting material on the top some of the semiconductor light sources by a printing process, the printing material being chosen depending on the desired sub-pixels, so that the converting material downconverts each first radiation, into a second desired radiation, wherein the first radiation is of a high energy first frequency when in operation and each second radiation is of a second, lower energy frequency when in operation.

In a preferred embodiment the converting material comprises phosphor.
In another preferred embodiment, the converting material comprises quantum dots.

In a further preferred embodiment the first radiation is of a high energy first frequency when in operation and each second radiation is of second, lower energy frequency when in operation and wherein a colour cut filter is arranged on the top of the printed converting material and wherein the colour cut filter is configured for blocking the first radiation of the high energy first frequency.

Furthermore, the object is achieved by a pixel module that is manufactured by the above described method.

Further objects, aspects and advantages of the invention will be explained by means of the following detailed description of preferred embodiments of the invention, when taken in conjunction with the figures of the enclosed drawings.
- FIG 1: shows a first pixel module according to the state of the art,
- FIG 2: shows a second optical module according to the state of the art,
- FIG 3: shows a first embodiment of a pixel module according to the invention,
- FIG 4: shows a second embodiment of a pixel module according to the invention,
- FIG 5: shows a third embodiment of a pixel module according to the invention.
- FIG 6: shows the application of a colour cut filter,
- FIG 7: shows another application of the colour cut filter,
- FIG 8: shows a fourth embodiment of a pixel module,
- FIG 9: shows an application of the optical filter,
- FIG 10: shows another application of the optical filter,
- FIG 11: shows a fifth embodiment of a pixel module,
- FIG 12: shows an application of the optical filter,
- FIG 13: shows the manufacturing of a pixel module.

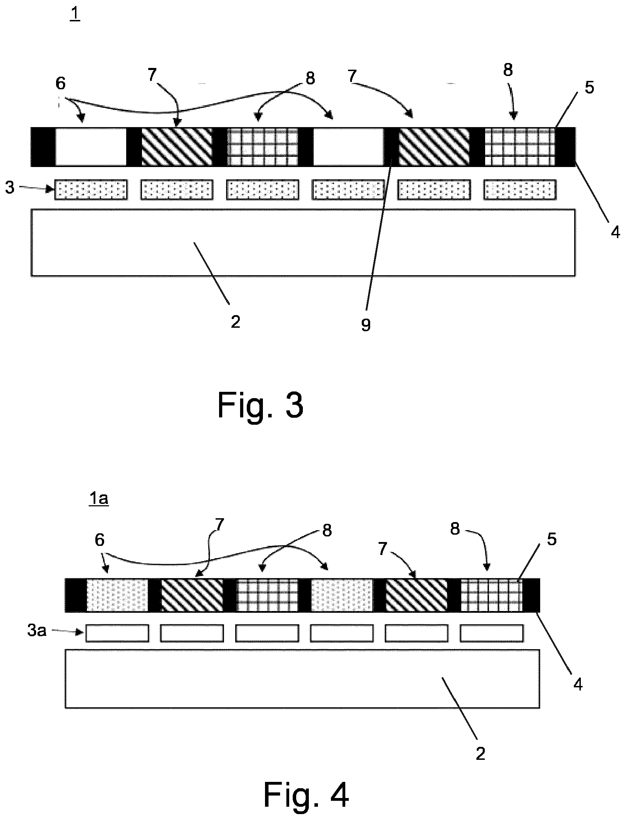

FIG 3 shows a first embodiment of a pixel module 1 according to the invention. The pixel module 1 comprises a substrate 2, for example a display substrate 2.

An array of blue emitting radiation LEDs 3 (blue LED 3) is arranged or produced on the substrate 2. Each single blue LED 3 can be produced on a single wafer substrate (not shown) and then transferred to the display substrate 2. Such an array can be transferred on the substrate 2 in a very short amount of time.

The pixel module 1 comprises further a colour layer 4 bonded on a top the light emissive side. The colour layer 4 comprises openings 5, which correspond to the desired sub-pixels; this means that the openings 5 represent the subpixels 6, 7, 8 after all. Some of the openings 5 are filled with a light converting material that is capable of converting the blue high energy light to red (Red Subpixel 7), and green light (Green Subpixel 8) corresponding to the desired radiation of the sub-pixels 6,7,8. The amount and or type of the converting material thus depends on the desired colour, which is to be emitted by the sub-pixels 7,8.

Some of the openings are gaps, that means without any converting material. Through these openings 5, the blue light of the blue emitting LEDs 3 can radiate through; this is equivalent to a "blue" sub-pixel 6.

So, the pixel module 1 comprising a plurality of sub-pixels 6,7,8, each having a radiation with the desired frequency

Pixel module 1 starts therefore from an array of blue LEDs 3 of blue monochromatic light. The LEDs 3 are transferred on the substrate 2 - individual red and green colour sub-pixels 7,8 or a blue sub-pixel 6 are generated using a colour layer 4 with properly tuned light converting properties. The colour layer 4 has side walls 9 surrounding the openings 5. The side walls 9 contain the light donwcoverting materials, which also assure proper separation between adjacent sub-pixels 6,7,8 as they prevent the light coming from one sub-pixel 6,7,8 diffusing laterally into the adjacent sub-pixel 6,7,8. In this example the starting monochromatic LEDs 3 are of a blue colour.

The openings 5 in the colour layer 4 may not necessarily correspond in a one to one fashion to the monochromatic emitting LEDs 3, arranged on the substrate 2. For instance, an opening 5 may cover an array of 2x2 or 3x3 LEDs without being limited to these strict values.

This allows for easier alignment between the LEDs 3 and the colour layer 4.

It is therefore possible by the invention, that starting from a monochromatic LED 3 array and adding properly tuned light converting materials by a colour layer 4 in the radiation of the LEDs 3, it is possible to produce large sized full colour MicroLED displays in a correspondingly required time and for a large format display. The LEDs 3 and the openings 5 have to be arranged in a pattern, suitable for a colour display.

FIG 4 shows a second embodiment of a pixel module 1a according to the invention.

The pixel module 1a comprises the substrate 2.

An array of UV-emitting radiation LEDs 3a (UV-LEDs 3a) is arranged or produced on the substrate 2. Each single LED 3 can be produced on a single wafer substrate (not shown) and then transferred to the substrate 2. Such an array can be transferred on a substrate 2 in a very short amount of time.

Pixel module 1a also has a colour layer 4. The colour layer 4 also has openings 5. In order to produce the desired red, blue, green sub-pixels 6,7,8 a correspondingly adapted converting material must now be filled in each of the openings 5. That means, that starting from a substrate 2 with UV ultraviolet (or violet) monochromatic LEDs 3a, all colour sub-pixels 6,7,8 are generated by downcoverting the emitted light to the corresponding red - green - blue light with the aid of properly tuned light converting materials.

The LEDs 3a can be configured as UV (ultraviolet radiating LEDs) or violet radiating LEDs.

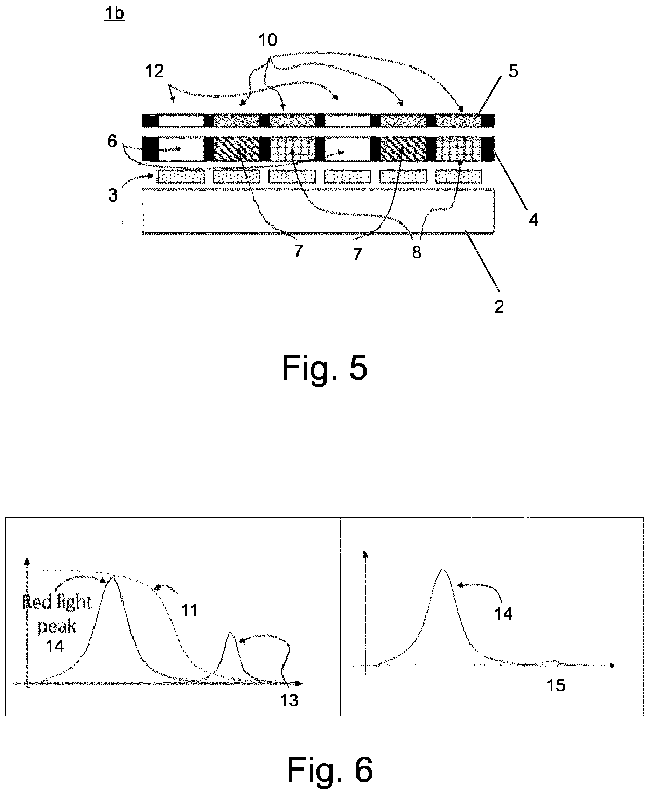

FIG 5 shows a third embodiment of a pixel module 1b according to the invention. The pixel module 1b comprises again the substrate 2.

Further the pixel module 1b comprises again blue emitting radiation LEDs 3. The pixel module 1b works also with other high emitting radiation LEDs.

Pixel module 1b comprises a colour layer 4 with openings 5 and converting material. The colour sub-pixels 7,8 are created again using donwconverting materials.

On the top of the colour layer 4, a colour cut filter 10 is arranged.
According to the invention, it was recognized, that if the light converting efficiency of the colour converting material is not close to 100%, than a non-negligible fraction of the initial light, here the blue light, may be able to escape the sub-pixel 7,8 together with desired, downconverted light, degrading the emitted colour of the sub-pixel 7,8.

So, for example is the red sub-pixel 7 generated starting from a blue LED 3. If a fraction of the initial blue light of the blue LED 3 is allowed to exit this sub-pixel 7, the primary red colour will shift slightly towards a magenta colour.

This is now prevented by the colour cut filter 10. The colour cut filter 10 can also be integrated in the colour layer 4.

Using the colour cut filter 10, the stray initial light of the blue LEDs 3 may be efficiently eliminated, leaving unaltered radiation of the green and red sub-pixels 7,8. According to the invention, it was recognized that just one colour cut filter 10 is needed, as it needs to absorb only the initial high energy blue light of the LEDs 3. The colour cut filter 10 also includes a neutral filter section 12 (gap) which transmits the blue light of the blue LEDs to produce the blue sub-pixels 6.

The colour cut filter 10 is preferably a low pass filter.
For the blue LEDs a blue colour cut filter 10 is used, in order to prevent blue light leakage from the non-blue sub-pixels 6,7.

Also, violet LEDs can be used instead of blue LEDs or other LEDs with highier frequency. In case of a violet LEDs a violet cut filter 10 should be used.

FIG 6 shows the application of the colour cut filter 10. The left diagram shows the unfiltered radiation of the red sub-pixel 7 (FIG 5). This shows a red-light peak 14 and a small blue light peak 13, which represents the passing, unwanted stray light. The filter function 11 is now applied to these two peaks 13,14. Subsequently, the radiation of the red sub-pixel 7 (Fig 5) after application of the filter function 11 can be seen in the right diagram. This shows a significantly reduced blue light peak 15 and a consistent red-light peak 14.

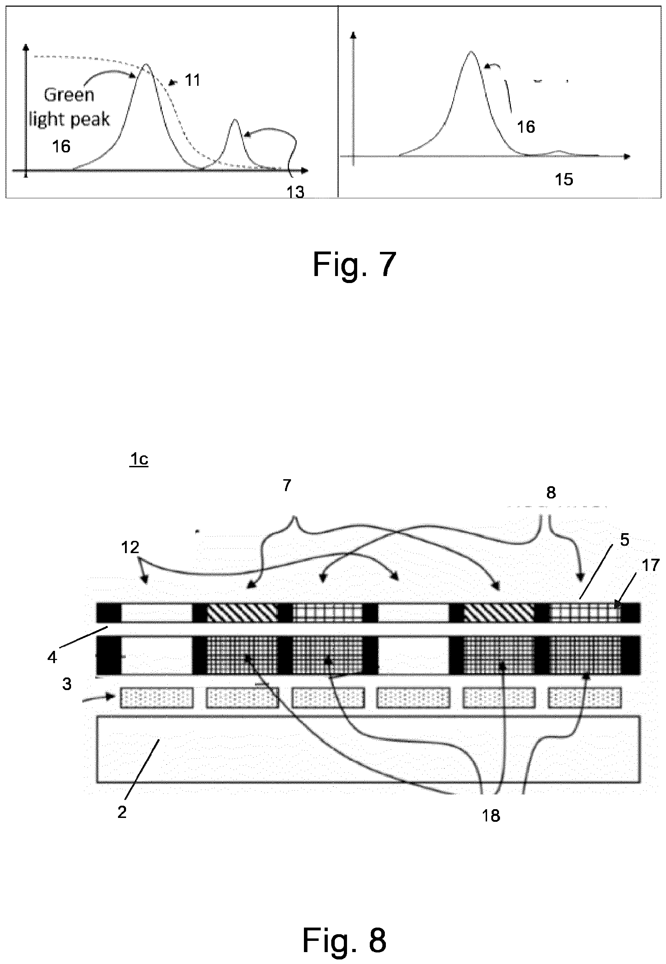

FIG 7 shows another application of the colour cut filter 10. The left diagram shows the unfiltered radiation of the green sub-pixel 8 (FIG 5). This shows a green light peak 16 and a small blue light peak 13, which represents the passing, unwanted stray light. The filter function 11 is now applied to these two peaks. Subsequently, the radiation of the green sub-pixel 8 (FIG 5) after application of the filter function 11 can be seen in the right diagram. This shows a significantly reduced blue light peak 15 and a consistent green light peak 16.

FIG 8 shows a fourth embodiment of a pixel module 1c according to the invention. Here the pixel module 1c comprises a substrate 2. Also, the
pixel module 1c comprises several blue LEDs 3 arranged on that substrate 2. Also, the pixel module 1c comprises a colour layer 4 with openings 5, corresponding to the openings 5 in the figures above.

Unlike the other figures, however, the openings 5 are filled with a converting material that does not lead the sub-pixels 6, 7 to their final colour. Rather, the converting material for all openings 5 is chosen so that these have a broader spectral characteristic than needed for the proper colour rendering.

In this example the pixel module 1c has blue LEDs 3 and openings 5 for green and red sub-pixels 7,8 and for blue sub-pixels 6. The openings 5 for creating the green and red sub-pixels 7,8 are filled with a downconverting material, for example the same phosphor substance, for instance a YAG (Yttrium Aluminium Garnet) downconverting material, that converts the incoming blue light to a broader spectrum yellow light.

That means that starting from a substrate 2 with blue LEDs 3, the red and green colour sub-pixels 7,8 are created using a YAG donwconverting material 18, which converts the incoming blue light to a broader, yellow light.

To generate nevertheless the green sub-pixels 8 and the red sub-pixels 7 from the yellow light an optical filter 17 used.

The optical filter 17 is a device that selectively transmits light of different
wave-lengths. Therefore , the optical filter 17 has the spectral characteristics aligned with the corresponding sub-pixel colour; that means the optical filter 17 is generated to pass the red part of the spectrum for the red sub-pixel 7 and the green part of the spectrum for the green part of the spectrum for the green sub-pixel 8. Also, the optical filter 17 has a gap 12 to pass the blue light emitted from the blue LEDs as a blue sub-pixel 6.

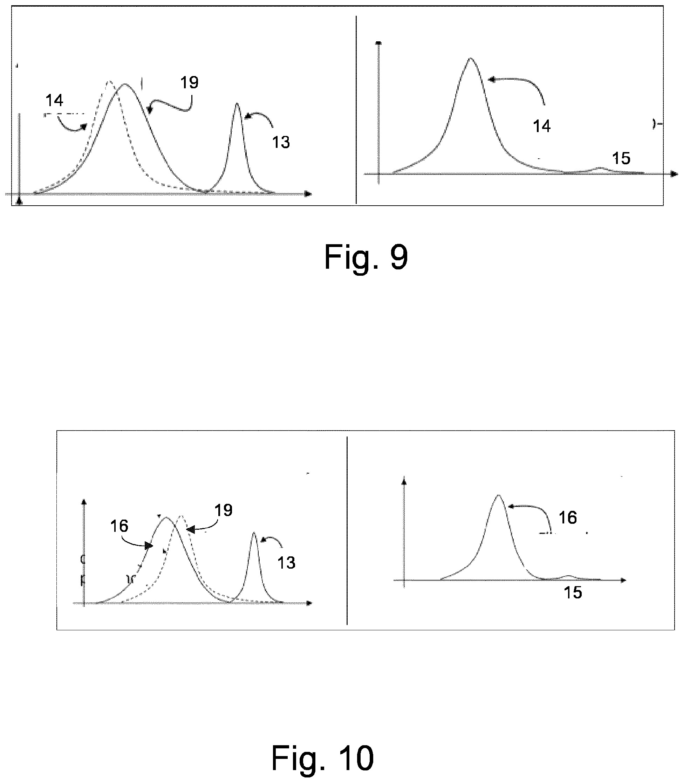

FIG 9 shows an application of the optical filter 17 (FIG 8). The left diagram shows the unfiltered radiation of the red sub-pixel 7 (FIG 8). This shows a desired red light peak 14 as well as a yellow light peak 19 and a small blue light peak 13. The yellow light peak 19 and the blue light peak 13 represents the transmitted, un-wanted stray light. Now the optical filter 17 (FIG 8) is applied. In this case, the optical filter 17 (FIG 8) is designed so that only the red light can pass though the optical filter 17 to generate the red sup-pixel 7 (FIG 8). Subsequently, the radiation of the red sub-pixel 7 (FIG 8) after application of the optical filter 17 can be seen in the right diagram. This shows a significantly reduced blue light peak 15, a reduced yellow peak and a consistent red light peak 14.

FIG 10 shows an application of the optical filter 17 (FIG 8), with a green light peak 16, the yellow light peak 19 and a big blue light peak 13 and a reduced blue light peak 15 similar to figure 9.

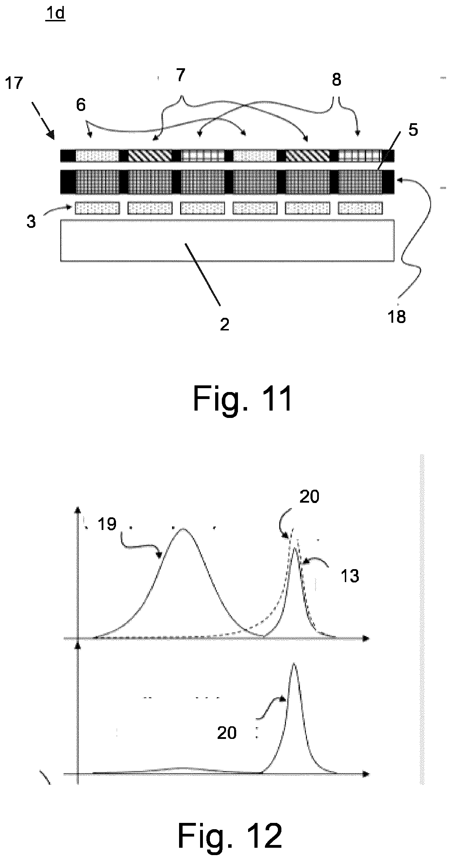

FIG 11 shows a fifth embodiment of a pixel module 1d according to the invention.

This embodiment is similar with the pixel module 1c of FIG 8 with the modification that all colour sub-pixels 6,7,8 are generated starting from the blue LEDs 3 arranged on the substrate 2 with the aid of YAG downconverting material 18. In this case, the YAG downconverting material 18 must be calibrated in such a way as to allow a significant part of the blue incoming light form the blue LEDs 3 to pass through the YAG downconverting material 18 without being affected by the downconverting process.

The final colour sub-pixels 6,7,8 are created by having a properly tuned red, green and blue optical filter 17. Although the addition of the YAG downconverting material 18 under the blue sub-pixel 6 decreases the overall efficiency of the pixel module 1d as part of blue light needed for the blue sub-pixel 6 is lost in the downconverting process.

An advantage of the pixel module 1d is the simpler implementation of a uniform YAG downconverting material, which can be implemented by a single process pass because of the same material. Also a standard optical filter 17 can be used, which produces same or very similar light spread functions for all sub-pixels 6,7,8 and a simple equalization scheme for the light outputs of sub-pixels 6,7,8. Since the green and red sub-pixel 7,8 are obtained from the original blue LED 3, their final brightness will be lower than that of the original blue monochromatic display.

FIG 12 shows an application of the optical filter 17 (FIG 11). The respective upper diagram shows the unfiltered emission of the blue sub-pixel 6 (FIG 11). This shows a desired blue light peak 20, a yellow light peak 19 and a small blue light peak 13.

The yellow light peak 19 represents the transmitted, unwanted scattered light. A filter function is now applied to these three peaks. In this case, the optical filter 17 (FIG 8) is designed at this point so that only the blue light can pass. Subsequently, the emission of the blue sub-pixel 7 (FIG 11) after application of the optical filter 17 can be seen in the lower diagram. This shows a significantly reduced yellow peak and the desired blue light peak 20.

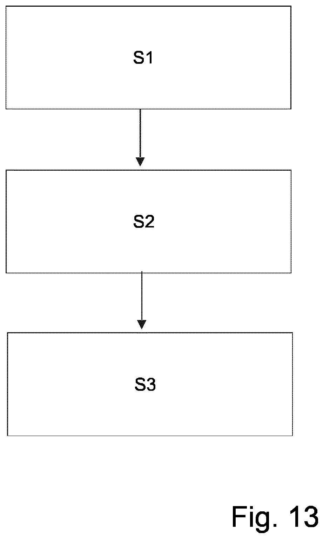

FIG 13 shows the manufacturing of a pixel module without a colour layer.
In a first step S1 a substrate is provided.

In a second step S2 a plurality of semiconductor light sources, for examples blue LEDs are arranged on the top of the substrate, the LEDs emit a first radiation of almost monochromatic light.

In a third step S3 converting material is printed on the top some of the semiconductor light sources by a printing process, the printing material being chosen depending on the desired sub-pixels, so that the converting material downconverts each first radiation of each sub-pixel, into a second desired radiation, wherein the first radiation is of a high energy first frequency when in operation and each second radiation is of a second, lower energy frequency when in operation

Similar to the pixel module of the figures 1 to 12 a colour cut filter can be uses, if the first radiation is downconverted directly to the second desired radiation by the converting material or an optical filter is used, when using the YAG converting material.

The invention has recognized the possibility to produce pixel modules for example full colour MicroLED displays starting from a high energy light monochromatic display.

## Claims

1. A pixel module (1,1a,..1d) comprising of at least a plurality of sub-pixels, the pixel module (1,1a,...,1d) comprising:
a substrate (2) for semiconductor light sources,
a plurality of semiconductor light sources that are mounted directly or indirectly on the top of the substrate, the semiconductor light sources emit a first radiation of almost monochromatic light,
a colour layer (4) arranged in the beam path of the first radiation,
the colour layer (4) having openings (5) corresponding to the resulting sub-pixels (6,7,8), wherein at least some of the openings (5) are filled with a converting material, which converts for each filled opening (5) the first radiation, into at least one desired second radiation, wherein the first radiation is of a high energy first frequency when in operation and each second radiation is of a lower energy frequency when in operation.

2. The pixel module (1,1a,,..,1d) according to claim 1, wherein the converting material for each sub-pixel (6,7) is configured to downconvert the first radiation with a first frequency to a desired second radiation with a second frequency, which is to emit the sub-pixel (6,7).

3. The pixel module (1,1a,,..,1d) according to any of the preceding claims, wherein the semiconductor light sources emit first blue high energy radiation.

4. The pixel module (1,1a,,..,1d) according to claim 3, wherein the converting material is configured such that at least one sub-pixel (7) emits red radiation and at least one sub-pixel (8) emits green radiation.

5. The pixel module (1,1a,,..,1d) according to any of preceding claims 1 to 4, wherein the semiconductor light sources emit first violet or ultraviolet high-energy radiation.

6. The pixel module (1,1a,1d) according to claim 5, wherein the converting material is configured such that at least one sub-pixel (7) emits red radiation and at least one sub-pixel (8) emits green radiation and at least one sub-pixel (6) emits blue high-energy radiation.

7. The pixel module(1,1a,..,1d) according to any of the preceding claims, wherein the first radiation is of a high energy first frequency when in operation and each second radiation is of second, lower energy frequency when in operation and wherein a colour cut filter (10) is arranged on the top of the colour layer (4) to cover at least the openings (5) having converting material.

8. The pixel module (1,1a,1d) according to claim 7, wherein the colour cut filter (10) is configured for blocking the first radiation of a high energy first frequency.

9. The pixel module (1,1a,..,1d) according to any of the preceding claims, wherein the first radiation is of a high energy first frequency when in operation and each second radiation is of a second, lower energy frequency when in operation, and wherein the second radiation with the second frequency does not correspond to the resulting radiation of the sub-pixels (6,7,8),
and wherein an optical filter (17) is arranged on the top of the colour layer (4) to cover at least the openings (5) with converting material.

10. The pixel module (1,1a,1d) according to claim 9, wherein the optical filter (17) is configured to allow the radiation which corresponds to the resulting de-sired radiation of the sub-pixels (6,7,8) to pass.

11. The pixel module (1,1a,1d) according to claim 9 or 10, wherein the converting material is identical for all openings (5).

12. The pixel module (1,1a,1d) according to claim 11, wherein the converting material comprises of YAG (Yttrium Aluminium Garnet) (18).

13. The pixel module (1,1a,1d) according to any of the preceding claims, where-in the semiconductor light sources are a micro LED.

14. A light emitting device comprising an array of pixel modules (1,1a,1d) ac-cording to any of the preceding claims.

15. A method for producing a pixel module, comprising the steps of:
- providing a substrate,
- mounting of a plurality of semiconductor light sources on the top of the substrate, the semiconductor light sources emit a first radiation of almost monochromatic light,
- printing converting material on the top some of the semiconductor light sources by a printing process, the printing material being chosen depending on the desired sub-pixels, so that the converting material downconverts each first radiation of each sub-pixel, into a second desired radiation, wherein the first radiation is of a high energy first frequency when in operation and each second radiation is of a second, lower energy frequency when in operation.

16. A method for producing a pixel module according to claim 15, **characterized in that** the converting material comprises phosphor.

17. A method for producing a pixel module according to claim 16 or 17, **characterized in that** the converting material comprises quantum dots.

18. A method for producing a pixel module according to any 15 to 17, wherein the first radiation is of a high energy first frequency when in operation and each second radiation is of second, lower energy frequency when in operation and wherein a colour cut filter is arranged on the top of the printed converting material and wherein the colour cut filter is configured for blocking the first radiation of a high energy first frequency.

19. A pixel module that is manufactured by the method according to any of claims 15 to 18.
